# EUROPEAN PATENT SPECIFICATION

(11) **EP 4 036 982 B1**
(45) Date of publication and mention of the grant of the patent: **12.03.2025**
(21) Application number: 22153861.4
(22) Date of filing: 28.01.2022
(51) Int. Cl.: H10K 50/14, H10K 50/19, H10K 59/122, H10K 59/35

(54) **DISPLAY APPARATUS**
ANZEIGEVORRICHTUNG
APPAREIL D'AFFICHAGE

(30) Priority: 02.02.2021 KR 20210014973
(43) Date of publication of application: 03.08.2022
(73) Proprietor: Samsung Display Co., Ltd., Yongin-si, Gyeonggi-do 17113 (KR)
(72) Inventor: KIM, Seil, Yongin-si, 17113 (KR); AHN, Hongkyun, Yongin-si, 17113 (KR); KO, Jungwoo, Yongin-si, 17113 (KR); YI, Sangmin, Yongin-si, 17113 (KR)
(74) Representative: Marks & Clerk LLP

(56) References cited:
- EP-A1- 3 680 946
- WO-A1-2020/227930
- US-A1- 2019 006 436
- US-A1- 2020 212 120
- US-A1- 2021 408 181

## Description

### BACKGROUND

### 1. Field

Aspects of one or more embodiments relate to a display apparatus.

### 2. Description of the Related Art

Display apparatuses are apparatuses that visually or graphically display data. Display apparatuses generally include a substrate partitioned into a display area and a peripheral area. In the display area, a scan line and a data line are insulated from each other, and a plurality of sub-pixels are included. In addition, in the display area, a thin-film transistor and a sub-pixel electrode electrically connected to the thin-film transistor may be provided corresponding to each of the sub-pixels. In addition, in the display area, an opposite electrode provided in common to the sub-pixels may be provided. In the peripheral area, various wires configured to transmit electrical signals to the display area, a scan driver, a data driver, a controller, a pad portion, and the like may be provided. US2019/006436A1 and US2020/212120A1 disclose display devices. In particular, US2019/006436A1 discloses a display apparatus comprising a 1-1 light-emitting device and a 1-2 light-emitting device each comprising a first charge generation layer; a second light-emitting device, adjacent to the 1-1 light-emitting device comprising a second charge generation layer; and a pixel-defining layer between the 1-1 light-emitting device and the 1-2 light-emitting device, wherein an upper surface of the pixel-defining layer comprises a groove.

Among the display apparatuses, a display apparatus such as an organic light-emitting display apparatus may have a structure in which a plurality of layers are stacked to allow each sub-pixel in the display area to emit light.

The above information disclosed in this Background section is only for enhancement of understanding of the background and therefore the information discussed in this Background section does not necessarily constitute prior art.

### SUMMARY

Aspects of one or more embodiments relate to a display apparatus, and for example, to a display apparatus for reducing a leakage current between sub-pixels.

Aspects of one or more embodiments include a display apparatus for reducing a leakage current between sub-pixels. However, such a technical problem is an example, and embodiments according to the present disclosure are not limited thereto.

Additional characteristics will be set forth in part in the description which follows and, in part, will be apparent from the description, or may be learned by practice of the presented embodiments of the disclosure.

According to one aspect there is provided a display apparatus in accordance with claim 1. Further aspects and preferred embodiments are set out in claim 2 et seq. A display apparatus includes a substrate, a 1-1 light-emitting device and a 1-2 light-emitting device arranged over the substrate and each including a first emission layer and a first charge generation layer, a second light-emitting device adjacent to the 1-1 light-emitting device and including a second emission layer including a material that emits light of a color different from that of the first emission layer and a second charge generation layer spaced apart from the first charge generation layer, and a pixel-defining layer including an opening exposing a center portion of a pixel electrode of each of the 1-1 light-emitting device, the 1-2 light-emitting device, and the second light-emitting device, wherein an upper surface of the pixel-defining layer between the 1-1 light-emitting device and the 1-2 light-emitting device includes a first groove concave toward the substrate, wherein the first charge generation layer is cut off around the first groove.

According to some embodiments, not forming part of the invention, the first groove may have a closed shape in a plan view.

According to the present invention, the first groove has an inverted tapered shape in a cross-sectional view.

According to some embodiments, the display apparatus may further include a third light-emitting device adjacent to the 1-1 light-emitting device and the second light-emitting device and configured to emit light of a color different from those of the 1-1 light-emitting device and the second light-emitting device, wherein a distance between a center portion of the 1-1 light-emitting device and a center portion of the 1-2 light-emitting device may be greater than a distance between a center portion of the second light-emitting device and a center portion of the third light-emitting device.

According to some embodiments, an area of an emission area of each of the 1-1 light-emitting device and the 1-2 light-emitting device may be greater than an area of an emission area of the second light-emitting device.

According to some embodiments, the 1-1 light-emitting device and the 1-2 light-emitting device may each include a material that emits light of a wavelength between about 450 nm and about 500 nm.

According to some embodiments, the display apparatus may further include an opposite electrode arranged over the pixel-defining layer, wherein the opposite electrode may include a portion surrounding the first groove.

According to some embodiments, an upper surface of the pixel-defining layer between the second light-emitting device and the 1-1 light-emitting device may include a second groove concave toward the substrate.

According to some embodiments, the display apparatus may further include an opposite electrode arranged over the pixel-defining layer, wherein the opposite electrode may include a portion surrounding each of the first groove and the second groove.

According to some embodiments, an upper surface of the pixel-defining layer between the second light-emitting device and the 1-1 light-emitting device may be flat.

According to some embodiments, the first emission layer may include a first sub-emission layer and a second sub-emission layer stacked on each other.

According to some embodiments, the first sub-emission layer and the second sub-emission layer may include materials that emit light of the same color.

According to some embodiments, the display apparatus may further include an auxiliary layer surrounding at least a portion of the first groove, wherein at least a portion of the auxiliary layer may protrude toward a center portion of the first groove.

According to some embodiments, the auxiliary layer may include at least one of silicon oxynitride, silicon oxide, or silicon nitride.

According to some embodiments, the display apparatus may further include a first functional layer overlapping the first charge generation layer and cut off around the first groove and a second functional layer overlapping the second charge generation layer and spaced apart from the first functional layer.

According to one or more embodiments, not forming part of the present invention, a display apparatus includes a substrate, a 1-1 light-emitting device and a 1-2 light-emitting device arranged over the substrate and each including a first emission layer and a first functional layer, a second light-emitting device adjacent to the 1-1 light-emitting device and including a second emission layer including a material that emits light of a color different from that of the first emission layer and a second functional layer spaced apart from the first functional layer, and a pixel-defining layer including an opening exposing a center portion of a pixel electrode of each of the 1-1 light-emitting device, the 1-2 light-emitting device, and the second light-emitting device, wherein an upper surface of the pixel-defining layer between the 1-1 light-emitting device and the 1-2 light-emitting device includes a first groove concave toward the substrate, wherein the first functional layer is cut off around the first groove.

According to some embodiments, the first groove may have an inverted tapered shape.

According to some embodiments, an upper surface of the pixel-defining layer between the second light-emitting device and the 1-1 light-emitting device may include a second groove concave toward the substrate.

According to some embodiments, the display apparatus may further include a first charge generation layer overlapping the first functional layer and cut off around the first groove and a second charge generation layer overlapping the second functional layer and spaced apart from the first charge generation layer.

According to some embodiments, the display apparatus may further include an auxiliary layer surrounding at least a portion of the first groove, wherein at least a portion of the auxiliary layer may protrude toward a center portion of the first groove.

At least some of the above and other features of the invention are set out in the claims.

### BRIEF DESCRIPTION OF THE DRAWINGS

The above and other aspects, features, and characteristics of certain embodiments of the disclosure will be more apparent from the following description taken in conjunction with the accompanying drawings, in which:
FIG. 1 is a schematic plan view of a display apparatus according to some embodiments;
FIG. 2 is an enlarged plan view of the region A of FIG. 1;
FIG. 3 is a cross-sectional view of the display apparatus, taken along the line III-III' of FIG. 2;
FIGS. 4A to 4C are schematic cross-sectional views of a first light-emitting device according to some embodiments;
FIG. 5 is a cross-sectional view of the display apparatus, taken along the line V-V' of FIG. 2;
FIG. 6 is a schematic cross-sectional view of a second light-emitting device according to some embodiments;
FIG. 7 is a schematic plan view of a display apparatus according to some embodiments;
FIG. 8 is a cross-sectional view of the display apparatus, taken along the line VIII-VIII' of FIG. 7;
FIG. 9 is a schematic plan view of a display apparatus according to some embodiments; and
FIG. 10 is a cross-sectional view of the display apparatus, taken along the line X-X' of FIG. 9.

### DETAILED DESCRIPTION

Reference will now be made in more detail to aspects of some embodiments, which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof.

As the present description allows for various changes and numerous embodiments, certain embodiments will be illustrated in the drawings and described in the written description. Effects and features of one or more embodiments and methods of accomplishing the same will become apparent from the following detailed description of the one or more embodiments, taken in conjunction with the accompanying drawings. However, the present embodiments may have different forms and should not be construed as being limited to the descriptions set forth herein.

One or more embodiments will be described below in more detail with reference to the accompanying drawings. Those elements that are the same or are in correspondence with each other are rendered the same reference numeral regardless of the figure number, and redundant descriptions thereof are omitted.

While such terms as "first" and "second" may be used to describe various elements, such elements must not be limited to the above terms. The above terms are used to distinguish one element from another.

The singular forms "a," "an," and "the" as used herein are intended to include the plural forms as well unless the context clearly indicates otherwise.

It will be understood that the terms "include," "comprise," and "have" as used herein specify the presence of stated features or elements but do not preclude the addition of one or more other features or elements.

It will be further understood that, when a layer, region, or element is referred to as being "on" another layer, region, or element, it can be directly or indirectly on the other layer, region, or element. That is, for example, intervening layers, regions, or elements may be present.

Sizes of elements in the drawings may be exaggerated or reduced for convenience of explanation. In other words, because sizes and thicknesses of elements in the drawings are arbitrarily illustrated for convenience of explanation, the following embodiments are not limited thereto.

When an embodiment may be implemented differently, a certain process order may be performed differently from the described order. For example, two consecutively described processes may be performed substantially at the same time or performed in an order opposite to the described order.

As used herein, the expression "A and/or B" refers to A, B, or A and B. In addition, the expression "at least one of A and B" refers to A, B, or A and B.

It will be further understood that, when layers, regions, or elements are referred to as being connected to each other, they may be directly connected to each other or indirectly connected to each other with intervening layers, regions, or elements therebetween. For example, when layers, regions, or elements are referred to as being electrically connected to each other, they may be directly electrically connected to each other or indirectly electrically connected to each other with intervening layers, regions, or elements therebetween.

The x-axis, the y-axis, and the z-axis are not limited to three axes of the rectangular coordinate system and may be interpreted in a broader sense. For example, the x-axis, the y-axis, and the z-axis may be perpendicular to one another or may represent different directions that are not perpendicular to one another.

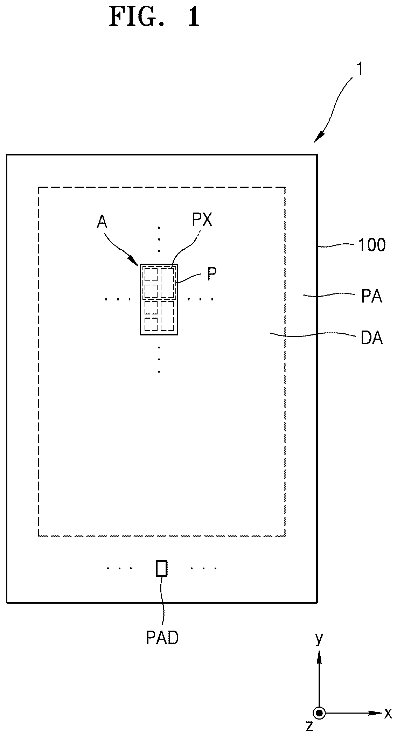

FIG. 1 is a schematic plan view of a display apparatus 1 according to some embodiments.

As shown in FIG. 1, the display apparatus 1 includes a display area DA where images may be displayed and a peripheral area PA arranged around (e.g., outside a periphery of) the display area DA. The display apparatus 1 may display images to the outside by using light emitted from the display area DA. Because the display apparatus 1 includes a substrate 100, the substrate 100 may be said to have the display area DA and the peripheral area PA.

The substrate 100 may include various materials such as glass, metal, or plastic. According to some embodiments, the substrate 100 may include a flexible material. In this regard, the flexible material refers to a substrate that may be bent, curved, folded, and/or rolled (e.g., with relative ease, or without damaging the substrate and corresponding components of the display apparatus 1). The substrate 100 including a flexible material may include, for example, ultra-thin glass, metal, or plastic, or any other suitable flexible substrate material.

A plurality of sub-pixels PX including various light-emitting devices such as an organic light-emitting diode may be arranged in the display area DA of the substrate 100. The plurality of sub-pixels PX may display images by emitting light. The sub-pixels PX may each emit red, green, or blue light. One pixel P may be implemented by driving rendering of the sub-pixels PX. For example, a pixel P may include a red sub-pixel PX, a green sub-pixel PX, and a blue sub-pixel PX.

As shown in FIG. 1, the plurality of sub-pixels PX may be arranged in a stripe arrangement (e.g., columns or rows). However, embodiments according to the present disclosure are not limited thereto. The plurality of sub-pixels PX may be arranged in various forms, such as a pentile arrangement or a mosaic arrangement, to implement an image.

When the display area DA is viewed in a planar shape, the display area DA may have a rectangular shape as shown in FIG. 1. According to some embodiments, the display area DA may have a polygonal shape, such as a triangle, a pentagon, or a hexagon, a circular shape, an oval shape, an irregular shape, or the like.

The peripheral area PA of the substrate 100 is an area arranged around (e.g., outside a footprint of) the display area DA and may be an area where no images are displayed. The peripheral area PA may entirely or partially surround the display area DA. Various wires configured to transmit electrical signals to be applied to the display area DA and a pad portion PAD to which a printed circuit board or a driver integrated circuit (IC) chip is attached may be located in the peripheral area PA.

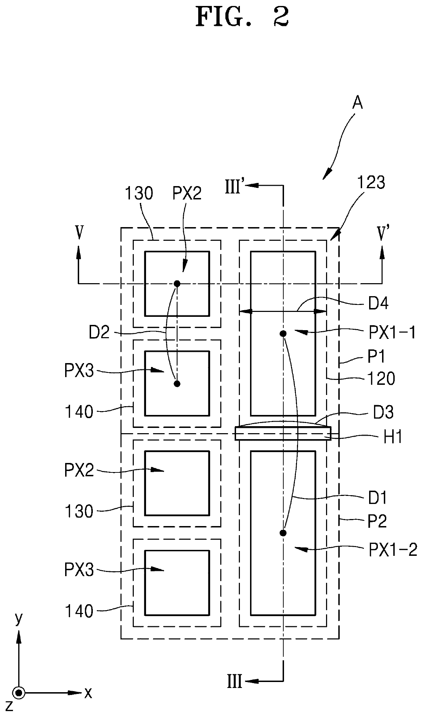

FIG. 2 is an enlarged plan view of the region A of FIG. 1. FIG. 2 shows an arrangement of a first pixel P1 and a second pixel P2 according to some embodiments.

In the embodiments described with respect to FIG. 2, the first pixel P1 may include a 1-1 sub-pixel PX1-1, a second sub-pixel PX2, and a third sub-pixel PX3, and the second pixel P2 may include a 1-2 sub-pixel PX1-2, the second sub-pixel PX2, and the third sub-pixel PX3. The first pixel P1 and the second pixel P2 may be adjacent to each other in a column direction (a y direction). First pixels P1 and second pixels P2 may be alternately arranged in the column direction (the y direction).

Hereinafter, an arrangement of each sub-pixel will be described with reference to FIG. 2. In the embodiments described with respect to FIG. 2, the 1-1 sub-pixel PX1-1, the 1-2 sub-pixel PX1-2, the second sub-pixel PX2, and the third sub-pixel PX3 may be arranged in a matrix shape. In the embodiments described with respect to FIG. 2, a row direction may be an x direction, and the column direction may be the y direction. One pixel may be arranged at a position where one row and one column cross each other.

An n-th column of a plurality of pixels may include the second sub-pixels PX2 and third sub-pixels PX3 alternately arranged. A (n+1)th column adjacent to the n-th column may include 1-1 sub-pixels PX1-1 and 1-2 sub-pixels PX1-2 alternately arranged. A (n+2)th column adjacent to the (n+1)th column may include the second sub-pixels PX2 and the third sub-pixels PX3 alternately arranged. An arrangement of sub-pixels included in the (n+2)th column may be the same as that of sub-pixels included in the n-th column. A (n+3)th column adjacent to the (n+2)th column may include the 1-1 sub-pixels PX1-1 and the 1-2 sub-pixels PX1-2 alternately arranged. An arrangement of sub-pixels included in the (n+3)th column may be the same as that of sub-pixels included in the (n+1)th column. Thus, according to some embodiments, the columns may include alternating arrangements of the second sub-pixels PX2 and the third sub-pixels PX3 grouped together in a column, followed by the 1-1 sub-pixels PX1-1 and 1-2 sub-pixels PX1-2 grouped together in the next column, with the pattern repeating in groups of two columns, such that the second sub-pixels PX2 and the third sub-pixels PX3 may be located in every other column, and the 1-1 sub-pixels PX1-1 and 1-2 sub-pixels PX1-2 may be located in every other column between or adjacent to the columns of the second sub-pixels PX2 and the third sub-pixels PX3.

An m-th row of the plurality of pixels may include the second sub-pixels PX2 and the 1-1 sub-pixels PX1-1 alternately arranged. A (m+1)th row adjacent to the m-th row may include the third sub-pixels PX3 and the 1-1 sub-pixels PX1-1 alternately arranged. A (m+2)th row adjacent to the (m+1)th row may include the second sub-pixels PX2 and the 1-2 sub-pixels PX1-2 alternately arranged. A (m+3)th row adjacent to the (m+2)th row may include the third sub-pixels PX3 and the 1-2 sub-pixels PX1-2 alternately arranged.

That is, the 1-1 sub-pixels PX1-1 may be integrally arranged at a position where the (n+1)th column and the m-th row meet each other and a position where the (n+1)th column and the (m+1)th row meet each other. The 1-2 sub-pixels PX1-2 may be integrally arranged at a position where the (n+1)th column and the (m+2)th row meet each other and a position where the (n+1)th column and the (m+3)th row meet each other.

The second sub-pixels PX2 may be arranged at a position where the n-th column and the m-th row meet each other, and the third sub-pixels PX3 may be arranged at a position where the n-th column and the (m+1)th row meet each other. In this regard, n and m may be natural numbers, that is, integers greater than 0.

Thus, as described above, and illustrated in FIG. 2, according to some embodiments, the second sub-pixels PX2 and the third sub-pixels PX3 may be located in alternating rows, and the 1-1 sub-pixels PX1-1 and the 1-2 sub-pixels PX1-2 may span across two rows, and alternate in groups of two rows along the column direction.

Due to the above arrangements, an emission area of the 1-1 sub-pixel PX1-1 and an emission area of the 1-2 sub-pixel PX1-2 may be greater than an emission area of the second sub-pixel PX2 or an emission area of the third sub-pixel PX3. For example, an emission area of the 1-1 sub-pixel PX1-1 and an emission area of the 1-2 sub-pixel PX1-2 may be at least (or about) twice as much as an emission area of the second sub-pixel PX2 or an emission area of the third sub-pixel PX3. Accordingly, a distance D1 between a center portion of the 1-1 sub-pixel PX1-1 and a center portion of the 1-2 sub-pixel PX1-2 may be greater than a distance D2 between a center portion of the second sub-pixel PX2 and a center portion of the third sub-pixel PX3. Due to the above configurations, emission life of the 1-1 sub-pixel PX1-1 and the 1-2 sub-pixel PX1-2 may be improved.

FIG. 2 shows the sub-pixels PX arranged in a stripe arrangement. However, embodiments according to the present disclosure are not limited thereto. The plurality of sub-pixels PX may be arranged in various forms such as a pentile arrangement or a mosaic arrangement.

The 1-1 sub-pixel PX1-1 and the 1-2 sub-pixel PX1-2 adjacent to each other may include a same first intermediate layer 120. The second sub-pixel PX2 adjacent to the 1-1 sub-pixel PX1-1 or the 1-2 sub-pixel PX1-2 may include a second intermediate layer 130 spaced apart from the first intermediate layer 120. The third sub-pixel PX3 may be adjacent to the 1-1 sub-pixel PX1-1 and the second sub-pixel PX2.
Alternatively, the third sub-pixel PX3 may be adjacent to the 1-2 sub-pixel PX1-2 and the second sub-pixel PX2. The third sub-pixel PX3 may include a third intermediate layer 140 spaced apart from the first intermediate layer 120 and the second intermediate layer 130.

The second sub-pixel PX2 may emit light of a color different from that of the 1-1 sub-pixel PX1-1. For example, the 1-1 sub-pixel PX1-1 may emit blue light, and the second sub-pixel PX2 may emit red light. The third sub-pixel PX3 may emit light of a color different from those of the 1-1 sub-pixel PX1-1 and the second sub-pixel PX2. For example, the 1-1 sub-pixel PX1-1 may emit blue light, the second sub-pixel PX2 may emit red light, and the third sub-pixel PX3 may emit green light.

A first groove H1 concave toward the substrate 100 may be arranged between the 1-1 sub-pixel PX1-1 and the 1-2 sub-pixel PX1-2. The first intermediate layer 120 may be cut off around (or at) the first groove H1. According to an embodiment not forming part of the present invention, the first groove H1 may have a closed shape in a plan view when viewed in a z-axis direction. For example, the first groove H1 may have a rectangular shape when viewed in the z-axis direction. In the embodiments described with respect to FIG. 2, the first groove H1 has a rectangular shape extending in an x-axis direction. In this regard, a length L1 of a long side of the first groove H1 may be greater than a length L2 of the first intermediate layer 120 in the x-axis direction. That is, one end of the first groove H1 extends further in a +x direction than a +x direction boundary of the first intermediate layer 120, and the other end of the first groove H1 extends further in a -x direction than a -x direction boundary of the first intermediate layer 120. As the first groove H1 is arranged as described above, the first intermediate layer 120 may be cut off.

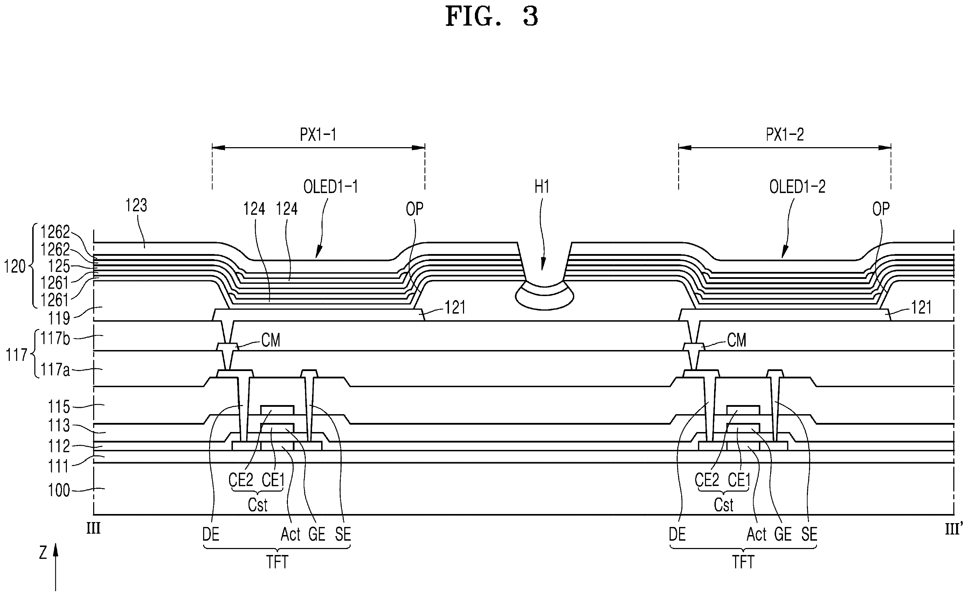

The first groove H1 may be provided in an upper surface of a pixel-defining layer 119 (refer to FIG. 3). An opposite electrode 123 covering all of the 1-1 sub-pixel PX1-1, the 1-2 sub-pixel PX1-2, the second sub-pixel PX2, and the third sub-pixel PX3 may be arranged over the pixel-defining layer 119 (refer to FIG. 3). The opposite electrode 123 may cover the entire display area DA. However, a partial area of the opposite electrode 123 may be cut off by the first groove H1. In other words, the opposite electrode 123 may cover the entire display area DA but may include a portion surrounding the first groove H1.

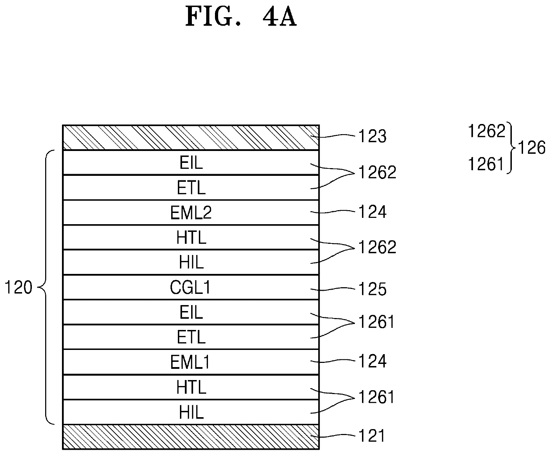

FIG. 3 is a cross-sectional view of the display apparatus 1, taken along the line III-III' of FIG. 2, and FIGS. 4A to 4C are schematic cross-sectional views of organic light-emitting diodes that may be employed as a light-emitting device of FIG. 3. Specifically, FIGS. 4A to 4C may be cross-sectional views of a pixel electrode 121, the first intermediate layer 120, and the opposite electrode 123 included in a 1-1 organic light-emitting diode OLED1-1 or a 1-2 organic light-emitting diode OLED1-2 according to embodiments.

As shown in FIG. 3, the display apparatus 1 may have a structure in which the substrate 100, a buffer layer 111, a first gate insulating layer 112, a second gate insulating layer 113, an interlayer insulating layer 115, a planarization layer 117, the pixel-defining layer 119, the first intermediate layer 120, and the opposite electrode 123 are stacked (or formed/deposited in a vertical or z direction).

The substrate 100 may include glass, metal, or polymer resin. When at least a portion of the display apparatus 1 is bent, or the display apparatus 1 is flexible, the substrate 100 needs to be flexible or bendable. In this case, the substrate 100 may include, for example, polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 may be variously modified, for example, to have a multilayer structure including two layers each including the polymer resin described above and a barrier layer including an inorganic material (e.g., silicon oxide, silicon nitride, silicon oxynitride, etc.) between the two layers. Further, in a case where the substrate 100 is not bent, the substrate 100 may include glass, etc.

The buffer layer 111 may be arranged on the substrate 100 to reduce or prevent penetration of foreign materials, moisture, or external air from below the substrate 100 and provide a flat surface on the substrate 100. The buffer layer 111 may include an inorganic material such as oxide or nitride, an organic material, or an organic-inorganic complex material and may have a single-layer or multi-layer structure of an inorganic material and an organic material. A barrier layer for preventing penetration of external air may be further between the substrate 100 and the buffer layer 111. The buffer layer 111 may include silicon oxide (SiO₂) or silicon nitride (SiNx).

A thin-film transistor TFT may be arranged on the buffer layer 111. The thin-film transistor TFT may include a semiconductor layer Act, a gate electrode GE, a source electrode SE, and a drain electrode DE. The thin-film transistor TFT may be connected to an organic light-emitting diode to drive the organic light-emitting diode OLED.

The semiconductor layer Act may be arranged on the buffer layer 111 and may include polysilicon. According to some embodiments, the semiconductor layer Act may include amorphous silicon. According to some embodiments, the semiconductor layer Act may include oxide of at least one material selected from the group including indium (In), gallium (Ga), tin (Sn), zirconium (Zr), vanadium (V), hafnium (Hf), cadmium (Cd), germanium (Ge), chromium (Cr), titanium (TI), and zinc (Zn). The semiconductor layer Act may include a channel region and source and drain regions doped with impurities.

The first gate insulating layer 112 may cover the semiconductor layer Act. The first gate insulating layer 112 may include an inorganic insulating material such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO₂). The first gate insulating layer 112 may have a single-layer or multi-layer structure including the inorganic insulating material described above.

The gate electrode GE may be arranged on the first gate insulating layer 112 to overlap the semiconductor layer Act. The gate electrode GE may include molybdenum (Mo), aluminum (Al), copper (Cu), titanium (Ti), etc. and may have a single-layer or multi-layer structure. For example, the gate electrode GE may have a multi-layer structure including a molybdenum (Mo) layer and an aluminum (Al) layer.

The second gate insulating layer 113 may cover the gate electrode GE. The second gate insulating layer 113 may include an inorganic insulating material such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO₂). The second gate insulating layer 113 may have a single-layer or multi-layer structure including the inorganic insulating material described above.

An upper electrode CE2 of a storage capacitor Cst may be arranged on the second gate insulating layer 113. The upper electrode CE2 of the storage capacitor Cst may overlap the gate electrode GE. In this regard, the gate electrode GE may be a lower electrode CE1 of the storage capacitor Cst. The upper electrode CE2 and the lower electrode CE1 may constitute the storage capacitor Cst. The upper electrode CE2 may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W) and/or copper (Cu) and may have a single-layer or multi-layer structure of the material described above.

The interlayer insulating layer 115 may cover the upper electrode CE2. The interlayer insulating layer 115 may include an inorganic insulating material such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO₂). The interlayer insulating layer 115 may have a single-layer or multi-layer structure including the inorganic insulating material described above.

The source electrode SE and the drain electrode DE of the thin-film transistor TFT may be arranged on the interlayer insulating layer 115. The source electrode SE and the drain electrode DE may include any suitable conductive material including, for example, molybdenum (Mo), aluminum (Al), copper (Cu), titanium (Ti), etc. and may have a multi-layer or single-layer structure including the material described above. For example, the source electrode SE and the drain electrode DE may have a multi-layer structure of Ti/Al/Ti.

The planarization layer 117 may be arranged on the interlayer insulating layer 115 to cover the source electrode SE and the drain electrode DE. The planarization layer 117 may include an organic material or an inorganic material and may have a single-layer structure or a multi-layer structure. The planarization layer 117 may include a first planarization layer 117a and a second planarization layer 117b. Accordingly, a conductive pattern such as wiring may be formed between the first planarization layer 117a and the second planarization layer 117b, which may be advantageous for high integration. A connection electrode CM may be arranged on the first planarization layer 117a.

The planarization layer 117 may include a general commercial polymer such as benzocyclobutene (BCB), polyimide, hexamethyldisiloxane (HMDSO), poly(methyl methacrylate) (PMMA), or polystyrene (PS), a polymer derivative having a phenol-based group, an acryl-based polymer, an imide-based polymer, an aryl ether-based polymer, an amide-based polymer, a fluorine-based polymer, a p-xylene-based polymer, a vinyl alcohol-based polymer, or the like. The planarization layer 117 may include an inorganic insulating material such as silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), or zinc oxide (ZnO₂). After the planarization layer 117 is formed, chemical mechanical polishing may be performed on an upper surface of the layer to provide a flat upper surface.

Organic light-emitting diodes, for example, the 1-1 and 1-2 organic light-emitting diodes OLED1-1 and OLED1-2, may be arranged on the second planarization layer 117b. The pixel electrode 121 of each of the organic light-emitting diodes, for example, the 1-1 and 1-2 organic light-emitting diodes OLED1-1 and OLED1-2, may be arranged on the second planarization layer 117b and may be electrically connected to the thin-film transistor TFT through the connection electrode CM.

The pixel electrode 121 may include conductive oxide such as indium tin oxide (ITO), indium zinc oxide (IZO), zinc oxide (ZnO), indium oxide (In₂O₃), indium gallium oxide (IGO), or aluminum zinc oxide (AZO). The pixel electrode 121 may include a reflective film including silver (Ag), magnesium (Mg), aluminum (Al), platinum (Pt), palladium (Pd), gold (Au), nickel (Ni), neodymium (Nd), iridium (Ir), chromium (Cr), or a compound thereof. For example, the pixel electrode 121 may have a structure having films including ITO, IZO, ZnO, or In₂O₃ on/under the reflective film described above. For example, the pixel electrode 121 may have a structure in which ITO/Ag/ITO is stacked.

The pixel-defining layer 119 on the planarization layer 117 may cover the edge of the pixel electrode 121 and may include an opening OP exposing a center portion of the pixel electrode 121. A size and shape of an emission area of the organic light-emitting diode OLED, that is, a sub-pixel PX, may be defined by the opening OP. The pixel-defining layer 119 may prevent an arc, etc. from occurring at the edge of the pixel electrode 121 by increasing a distance between the edge of the pixel electrode 121 and the opposite electrode 123 arranged over the pixel electrode 121. The pixel-defining layer 119 may include an organic insulating material such as polyimide, polyamide, acrylic resin, HMDSO, and phenolic resin and may be formed by a method such as spin coating.

The first intermediate layer 120 may be arranged on the pixel-defining layer 119 and the pixel electrode 121. The first intermediate layer 120 may include a first emission layer 124 for emitting light, a first functional layer 126 for helping emission of the first emission layer 124, and a first charge generation layer 125.

As shown in FIGS. 3 and 4A, the first intermediate layer 120 of an organic light-emitting diode according to some embodiments may include the first emission layer 124, the first charge generation layer 125, and the first functional layer 126.

The first emission layer 124 may include a first sub-emission layer EML1 and a second sub-emission layer EML2 stacked to be spaced apart from each other. The first emission layer 124 may be a layer in which holes and electrons are combined to emit light. The first sub-emission layer EML1 and the second sub-emission layer EML2 may include materials that emit light of the same color. For example, the first sub-emission layer EML1 and the second sub-emission layer EML2 may include a material that emits light of a wavelength between about 450 nm and about 500 nm. That is, the first sub-emission layer EML1 and the second sub-emission layer EML2 may include a material that emits blue light. Accordingly, the 1-1 organic light-emitting diode OLED1-1 or the 1-2 organic light-emitting diode OLED1-2 may include a material that emits light of a wavelength between about 450 nm and about 500 nm.

The first charge generation layer 125 may lower the Fermi barrier to help movement of electrons and holes. The first charge generation layer 125 may include a plurality of layers including an N-type charge generation layer including an N-type dopant material and an N-type host material and a P-type charge generation layer including a P-type dopant material and a P-type host material.

The first functional layer 126 may overlap the first charge generation layer 125. The first functional layer 126 may include a first sub-functional layer 1261 and a second sub-functional layer 1262. The first sub-functional layer 1261 may include a hole injection layer HIL, a hole transport layer HTL, an electron transport layer ETL, and an electron injection layer EIL. The hole injection layer HIL may be a layer into which holes transferred from the pixel electrode 121 or a charge generation layer are injected. The hole transport layer HTL may transfer holes transferred from the hole injection layer HIL to the first emission layer 124. The electron injection layer EIL may be a layer into which electrons transferred from the opposite electrode 123 or the charge generation layer are injected. The electron transport layer ETL may transfer electrons transferred from the electron injection layer EIL to an emission layer. That is, the hole injection layer HIL, the hole transport layer HTL, the first sub-emission layer EML1, the electron transport layer ETL, and the electron injection layer EIL may be sequentially stacked to emit light.

The second sub-functional layer 1262 may also have the same stacked structure as the first sub-functional layer 1261. That is, the second sub-functional layer 1262 may also have a stacked structure of the hole injection layer HIL, the hole transport layer HTL, the electron transport layer ETL, and the electron injection layer EIL. Accordingly, the hole injection layer HIL, the hole transport layer HTL, the second sub-emission layer EML2, the electron transport layer ETL, and the electron injection layer EIL may be sequentially stacked to emit light.

Although FIG. 4A shows the first sub-functional layer 1261 and the second sub-functional layer 1262 including the hole injection layer HIL, the hole transport layer HTL, the electron transport layer ETL, and the electron injection layer EIL, the first sub-functional layer 1261 and the second sub-functional layer 1262 may not include the electron injection layer EIL.

Hereinafter, a stacked structure of each layer will be described in more detail with reference to FIG. 4A. The first intermediate layer 120 may be arranged between the pixel electrode 121 and the opposite electrode 123. The hole injection layer HIL, the hole transport layer HTL, the first sub-emission layer EML1, the electron transport layer ETL, the electron injection layer EIL, the first charge generation layer 125, the hole injection layer HIL, the hole transport layer HTL, the second sub-emission layer EML2, the electron transport layer ETL, the electron injection layer EIL, and the opposite electrode 123 may be sequentially stacked on the pixel electrode 121.

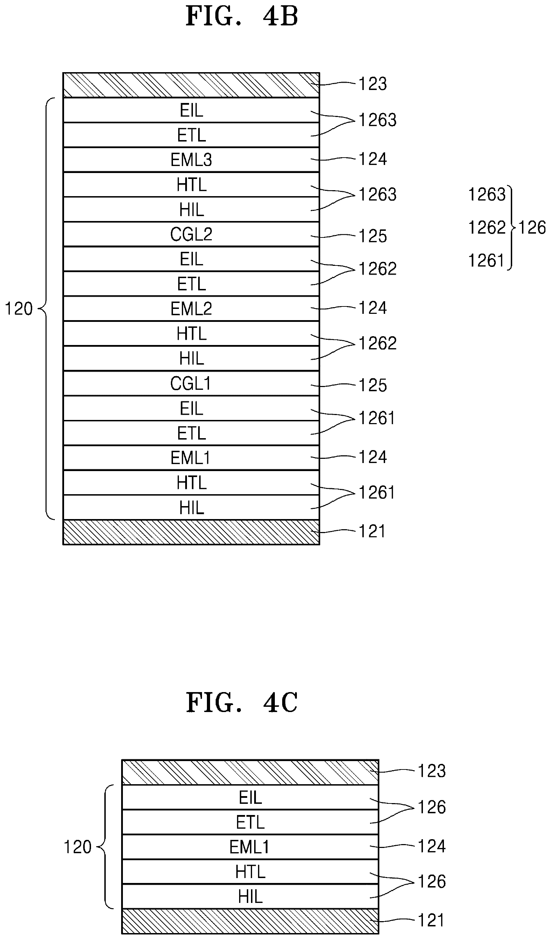

Referring to FIG. 4B, a stacked structure of an organic light-emitting diode according to some embodiments is as follows. The first emission layer 124 of an organic light-emitting diode according to some embodiments may include the first sub-emission layer EML1, the second sub-emission layer EML2, and a third sub-emission layer EML3 stacked to be spaced apart from one another. The first sub-emission layer EML1, the second sub-emission layer EML2, and the third sub-emission layer EML3 may include materials that emit light of the same color. For example, the first sub-emission layer EML1, the second sub-emission layer EML2, and the third sub-emission layer EML3 may include a material that emits light of a wavelength between about 450 nm and about 500 nm. That is, the first sub-emission layer EML1, the second sub-emission layer EML2, and the third sub-emission layer EML3 may include a material that emits blue light.

The first charge generation layer 125 may include a first sub-charge generation layer CGL1 and a second sub-charge generation layer CGL2. The first sub-charge generation layer CGL1 and the second sub-charge generation layer CGL2 may each include a plurality of layers including an N-type charge generation layer including an N-type dopant material and an N-type host material and a P-type charge generation layer including a P-type dopant material and a P-type host material.

The first functional layer 126 may include the first sub-functional layer 1261, the second sub-functional layer 1262, and a third sub-functional layer 1263. The third sub-functional layer 1263 may also have the same stacked structure as that of the first sub-functional layer 1261 described above. That is, the third sub-functional layer 1263 may also have a stacked structure of the hole injection layer HIL, the hole transport layer HTL, the electron transport layer ETL, and the electron injection layer EIL. Accordingly, the hole injection layer HIL, the hole transport layer HTL, the third sub-emission layer EML3, the electron transport layer ETL, and the electron injection layer EIL may be sequentially stacked to emit light. Although FIG. 4B shows the first sub-functional layer 1261, the second sub-functional layer 1262, and the third sub-functional layer 1263 including the hole injection layer HIL, the hole transport layer HTL, the electron transport layer ETL, and the electron injection layer EIL, the first sub-functional layer 1261, the second sub-functional layer 1262, and the third sub-functional layer 1263 may not include the electron injection layer EIL.

Although FIG. 4A shows a structure in which two sub-emission layers of an organic light-emitting diode are stacked, embodiments according to the present disclosure are not limited thereto. Various modifications may be made, for example, three or more sub-emission layers may be stacked as shown in FIG. 4B, or only one sub-emission layer may be included as shown in FIG. 4C.

Referring to FIG. 4B, the first intermediate layer 120 may be arranged between the pixel electrode 121 and the opposite electrode 123. The hole injection layer HIL, the hole transport layer HTL, the first sub-emission layer EML1, the electron transport layer ETL, the electron injection layer EIL, the first sub-charge generation layer CGL1, the hole injection layer HIL, the hole transport layer HTL, the second sub-emission layer EML2, the electron transport layer ETL, the electron injection layer EIL, the second sub-charge generation layer CGL2, the hole injection layer HIL, the hole transport layer HTL, the third sub-emission layer EML3, the electron transport layer ETL, the electron injection layer EIL, and the opposite electrode 123 may be sequentially stacked on the pixel electrode 121.

Referring to FIG. 4C, a stacked structure of an organic light-emitting diode according to some embodiments is as follows. The first intermediate layer 120 may be arranged between the pixel electrode 121 and the opposite electrode 123. The first intermediate layer 120 may include the first functional layer 126 and the first emission layer 124. Specifically, the hole injection layer HIL, the hole transport layer HTL, the first emission layer 124, the electron transport layer ETL, the electron injection layer EIL, and the opposite electrode 123 may be sequentially stacked on the pixel electrode 121. In the embodiments illustrated with respect to FIG. 4C, no charge generation layer may be stacked.

The opposite electrode 123 may be arranged on the first intermediate layer 120. The opposite electrode 123 may include a conductive material having a low work function. For example, the opposite electrode 123 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the opposite electrode 123 may further include a layer, such as ITO, IZO, ZnO, or In₂O₃, on a (semi)transparent layer including the material described above.

Layers from the pixel electrode 121 to the opposite electrode 123 may constitute an organic light-emitting diode. An upper layer for protecting the opposite electrode 123 and increasing light extraction efficiency may be formed on the opposite electrode 123.

The first groove H1 may be arranged between the 1-1 sub-pixel PX1-1 and the 1-2 sub-pixel PX1-2. The first groove H1 is concave in a direction from an upper surface of the pixel-defining layer 119 toward the substrate 100. The first groove H1 includes an inverted tapered shape in a cross-sectional view. In other words, the first groove H1 has an undercut shape. As the first groove H1 of such a shape is provided, the first intermediate layer 120 may be cut off in the first groove H1.

That is, the first charge generation layer 125 and the first functional layer 126 may be cut off around the first groove H1. As in the embodiments of FIGS. 4A and 4B, when a plurality of emission layers are stacked, a charge generation layer may be arranged between the emission layers. In this case, a leakage current may occur due to the charge generation layer, and thus, an adjacent organic light-emitting diode may emit light. For example, when a common voltage and a driving voltage are applied to allow the 1-1 organic light-emitting diode OLED1-1 to emit light, a current flows to the 1-2 organic light-emitting diode OLED1-2 through the first charge generation layer 125, and thus, the 1-2 organic light-emitting diode OLED1-2 may emit dim light. According to some embodiments, the first intermediate layer 120 may be cut off by forming the first groove H1, and thus, such a leakage current may be reduced.

According to some embodiments, as illustrated with respect to FIG. 4C, an organic light-emitting diode may not include the first charge generation layer 125. However, a problem in which a leakage current flows through the first functional layer 126 may still occur. Accordingly, the first intermediate layer 120 according to the embodiments illustrated with respect to FIG. 4C may also be cut off by the first groove H1 to reduce a leakage current.

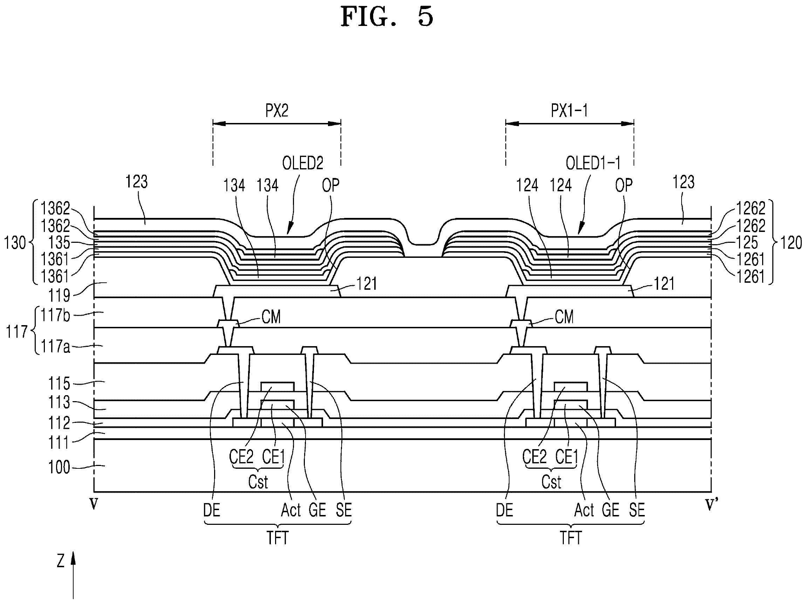

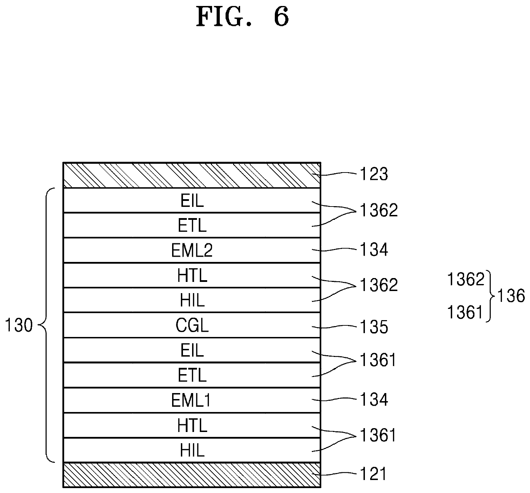

FIG. 5 is a cross-sectional view of the display apparatus 1, taken along line V-V' of FIG. 2. FIG. 6 is a schematic cross-sectional view of a second organic light-emitting diode OLED2 of FIG. 5. For example, FIG. 6 may be a cross-sectional view of the pixel electrode 121, the second intermediate layer 130, and the opposite electrode 123 included in the second organic light-emitting diode OLED2. The same reference numerals as in FIG. 3 denote the same elements, and thus, redundant descriptions thereof are omitted.

As shown in FIGS. 5 and 6, the second intermediate layer 130 of an organic light-emitting diode according to some embodiments may include a second emission layer 134, a second charge generation layer 135, and a second functional layer 136. The second emission layer 134 may include the first sub-emission layer EML1 and the second sub-emission layer EML2 stacked to be spaced apart from each other. The first sub-emission layer EML1 and the second sub-emission layer EML2 may include materials that emit light of the same color. For example, the first sub-emission layer EML1 and the second sub-emission layer EML2 may include a material that emits light of a wavelength between about 610 nm and about 760 nm. That is, the first sub-emission layer EML1 and the second sub-emission layer EML2 may include a material that emits red light. Because the second organic light-emitting diode OLED2 includes the second emission layer 134, the second organic light-emitting diode OLED2 may be said to include a material that emits light of a wavelength between about 610 nm and about 760 nm.

As the first charge generation layer 125 does, the second charge generation layer 135 may include a plurality of layers including an N-type charge generation layer including an N-type dopant material and an N-type host material and a P-type charge generation layer including a P-type dopant material and a P-type host material.

As the first functional layer 126 does, the second functional layer 136 may also include a first sub-functional layer 1361 and a second sub-functional layer 1362.

A stacking order of an emission layer, a functional layer, and a charge generation layer included in the second intermediate layer 130 may be the same as a stacking order of an emission layer, a functional layer, and a charge generation layer included in the first intermediate layer 120. However, the emission layer included in the second intermediate layer 130 may be the second emission layer 134 including a material that emits light of a color different from that of the first emission layer 124 and spaced apart from the first emission layer 124. In addition, the charge generation layer included in the second intermediate layer 130 may be the second charge generation layer 135 spaced apart from the first charge generation layer 125. In addition, the functional layer included in the second intermediate layer 130 may be the second functional layer 136 overlapping the second charge generation layer 135 and spaced apart from the first functional layer 126. In FIG. 6, an organic light-emitting diode according to some embodiments is shown as including the first sub-emission layer EML1 and the second sub-emission layer EML2 stacked to be spaced apart from each other and including the single-layered second charge generation layer 135. However, embodiments according to the present disclosure are not limited thereto. As shown in FIGS. 4B and 4C, the second intermediate layer 130 may have a structure having a single-layered emission layer or a three-layered emission layer.

The second intermediate layer 130 including the second emission layer 134 and the second charge generation layer 135 may be spaced apart from the first intermediate layer 120. Accordingly, a problem in that an adjacent organic light-emitting diode emits light due to a leakage current may not occur between the second organic light-emitting diode OLED2 and the 1-1 organic light-emitting diode OLED1-1. Accordingly, no groove may be formed in the pixel-defining layer 119 between the second organic light-emitting diode OLED2 and the 1-1 organic light-emitting diode OLED1-1, and an upper surface of the pixel-defining layer 119 may be flat.

A third organic light-emitting diode according to some embodiments may be an organic light-emitting diode including an emission area of the third sub-pixel PX3. The third organic light-emitting diode may include the third intermediate layer 140. The third intermediate layer 140 includes an emission layer that emits different light from the first emission layer 124 and the second emission layer 134. For example, an emission layer included in the third intermediate layer 140 may include a material that emits light of a wavelength between about 500 nm and about 570 nm. That is, an emission layer included in the third intermediate layer 140 may include a material that emits green light. A stacking order of an emission layer, a functional layer, and a charge generation layer included in the third intermediate layer 140 may be the same as the stacking order of the emission layer, the functional layer, and the charge generation layer included in the first intermediate layer 120 or the second intermediate layer 130, and thus, a detailed description thereof is omitted below.

The third intermediate layer 140 may be spaced apart from the first intermediate layer 120 and the second intermediate layer 130. Accordingly, a problem in that an adjacent organic light-emitting diode emits light due to a leakage current may not occur between the third organic light-emitting diode and the second organic light-emitting diode OLED2 or between the third organic light-emitting diode and the 1-1 organic light-emitting diode OLED1-1. Accordingly, no groove may be formed in the pixel-defining layer 119 between the third organic light-emitting diode and the second organic light-emitting diode OLED2 or between the third organic light-emitting diode and the 1-1 organic light-emitting diode OLED1-1, and an upper surface of the pixel-defining layer 119 may be flat.

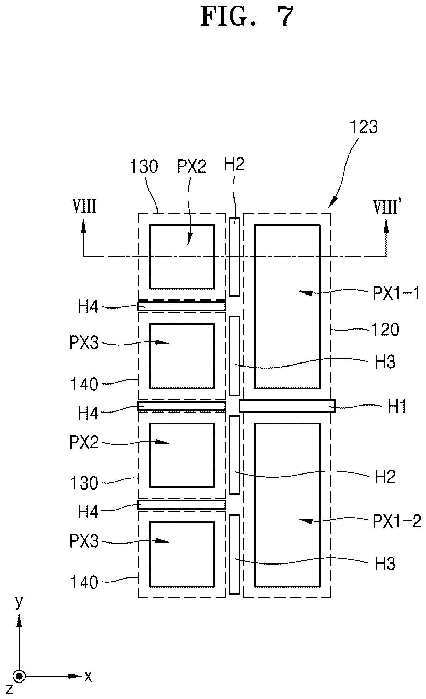

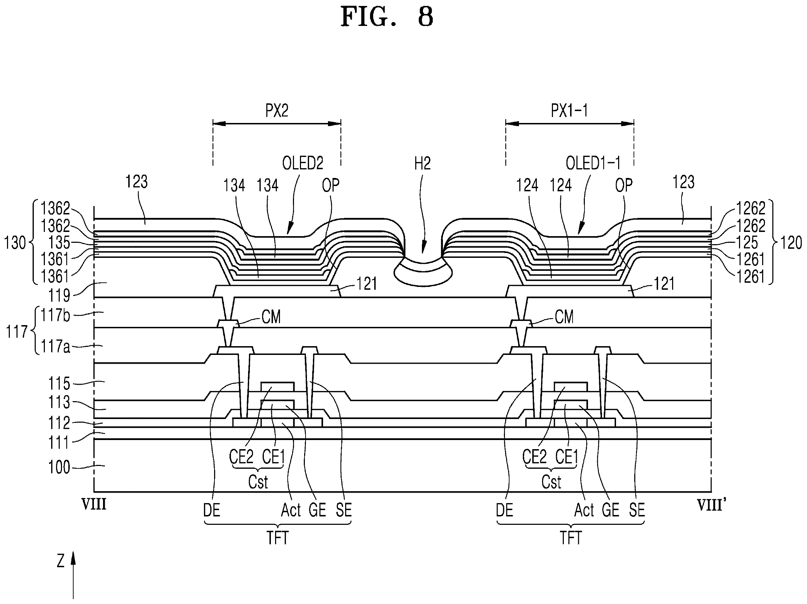

FIG. 7 is a schematic plan view of a display apparatus according to some embodiments. FIG. 8 is a cross-sectional view of the display apparatus, taken along the line VIII-VIII' of FIG. 7.

As shown in FIGS. 7 and 8, a second groove H2 concave toward the substrate 100 may be arranged in an upper surface of the pixel-defining layer 119 between the 1-1 sub-pixel PX1-1 and the second sub-pixel PX2. As described above, because the first intermediate layer 120 and the second intermediate layer 130 are spaced apart from each other, a problem in that an adjacent sub-pixel emits light due to a leakage current caused by a charge generation layer or a functional layer does not occur. However, end portions of the first intermediate layer 120 and the second intermediate layer 130 may overlap each other due to a process problem. In this case, the first charge generation layer 125 of the first intermediate layer 120 and the second charge generation layer 135 of the second intermediate layer 130 may be electrically connected to each other to cause a leakage current. To prevent this, the second groove H2 may be formed between the 1-1 sub-pixel PX1-1 and the second sub-pixel PX2. A cross-sectional shape of the second groove H2 may be the same as that of the first groove H1. That is, the second groove H2 may include an inverted tapered structure or may have an undercut shape.

For the same reason, a third groove H3 may be arranged between the 1-1 sub-pixel PX1-1 and the third sub-pixel PX3. In addition, a fourth groove H4 may be arranged between the third sub-pixel PX3 and the second sub-pixel PX2. In the same manner, the second groove H2 may also be arranged between the 1-2 sub-pixel PX1-2 and the second sub-pixel PX2, and the third groove H3 may also be arranged between the 1-2 sub-pixel PX1-2 and the third sub-pixel PX3.

As described above, the pixel-defining layer 119 may include an opening exposing a center portion of the pixel electrode 121 of each of the 1-1 sub-pixel PX1-1, the 1-2 sub-pixel PX1-2, the second sub-pixel PX2, and the third sub-pixel PX3. The opposite electrode 123 covering the 1-1 sub-pixel PX1-1, the 1-2 sub-pixel PX1-2, the second sub-pixel PX2, and the third sub-pixel PX3 may be arranged over the pixel-defining layer 119. A partial area of the opposite electrode 123 may be cut off by the first to fourth grooves H1 to H4. That is, the opposite electrode 123 may cover the entire display area DA and may include a portion surrounding each of the first to fourth grooves H1 to H4.

In the cross-sectional view of FIG. 8, the opposite electrode 123 seems to be cut off. However, referring to the plan view of FIG. 7, the opposite electrode 123 is cut off in the first to fourth grooves H1 to H4 but is connected at a portion where the first to fourth grooves H1 to H4 are not arranged, and thus, the sub-pixels PX may receive a common voltage from the same opposite electrode 123.

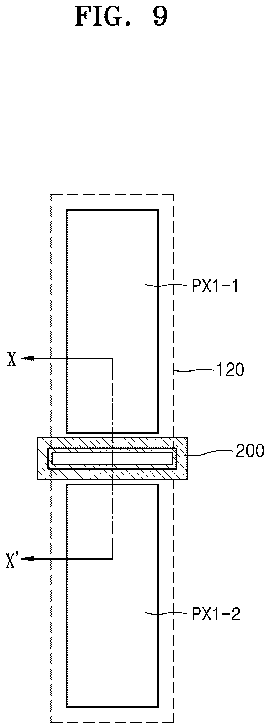

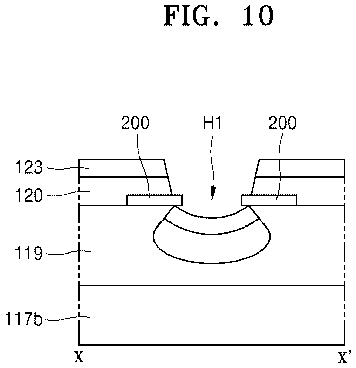

FIG. 9 is a schematic plan view of a display apparatus according to some embodiments. FIG. 10 is a cross-sectional view of the display apparatus, taken along the line X-X' of FIG. 9.

As shown in FIGS. 9 and 10, when viewed from the z-axis, an auxiliary layer 200 may be arranged on the pixel-defining layer 119 to surround at least a portion of the first groove H1. At least a portion of the auxiliary layer 200 may protrude toward a center portion of the first groove H1. The auxiliary layer 200 may include at least one of silicon oxide (SiO₂), silicon nitride (SiNₓ), or silicon oxynitride (SiOₓN_{y}). The auxiliary layer 200 has a difference in selectivity from the pixel-defining layer 119, and thus, degrees of being etched during etching may be different. Due to the difference in selectivity, a portion of the auxiliary layer 200 may protrude toward a center portion of the first groove H1. As a portion of the auxiliary layer 200 protrudes toward a center portion of the first groove H1, it may be easy to form an undercut shape. Accordingly, it may help to cut off the first intermediate layer 120 including the first functional layer 126 and the first charge generation layer 125.

As described above, according to one or more embodiments, a display apparatus for reducing a leakage current between sub-pixels may be implemented. However, embodiments according to the present disclosure are not limited by such an effect.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (1) comprising:
a substrate (100);
a 1-1 light-emitting device, PX1-1, and a 1-2 light-emitting device, PX1-2, over the substrate (100) and each comprising a first emission layer (124) and a first charge generation layer (125);
a second light-emitting device, PX2, adjacent to the 1-1 light-emitting device, PX1-1, and comprising a second emission layer (134) comprising a material that emits light of a color different from that of the first emission layer (124) and a second charge generation layer (135) spaced apart from the first charge generation layer (125); and
a pixel-defining layer (119) comprising an opening, OP, exposing a center portion of a pixel electrode (121) of each of the 1-1 light-emitting device, PX1-1, the 1-2 light-emitting device, PX1-2, and the second light-emitting device, PX2,
wherein an upper surface of the pixel-defining layer (119) between the 1-1 light-emitting device, PX1-1, and the 1-2 light-emitting device, PX1-2, comprises a first groove, H1, concave toward the substrate (100),
wherein the first charge generation layer (125) is cut off at the first groove, H1; and
wherein the first groove, H1, has an inverted tapered shape in a cross-sectional view.

2. The display apparatus of claim 1, further comprising a third light-emitting device, PX3, adjacent to the 1-1 light-emitting device and the second light-emitting device and configured to emit light of a color different from those of the 1-1 light-emitting device and the second light-emitting device,
wherein a distance, D1, between a center portion of the 1-1 light-emitting device, PX1-1, and a center portion of the 1-2 light-emitting device, PX1-2, is greater than a distance between a center portion of the second light-emitting device, PX2, and a center portion of the third light-emitting device, PX3.

3. The display apparatus of any preceding claim, wherein an area of an emission area of each of the 1-1 light-emitting device, PX1-1, and the 1-2 light-emitting device, PX1-2, is greater than an area of an emission area of the second light-emitting device, PX2.

4. The display apparatus of claim 3, wherein the 1-1 light-emitting device, OLED1-1, and the 1-2 light-emitting device, OLED1-2, each comprise a material that emits light of a wavelength between 450 nm and 500 nm.

5. The display apparatus of any preceding claim, further comprising an opposite electrode (123) arranged over the pixel-defining layer (119),
wherein the opposite electrode (123) comprises a portion surrounding the first groove, H1.

6. The display apparatus of any preceding claim, wherein an upper surface of the pixel-defining layer (119) between the second light-emitting device, PX2, and the 1-1 light-emitting device, PX1-1, comprises a second groove, H2, concave toward the substrate (100).

7. The display apparatus of claim 6, further comprising an opposite electrode (123) arranged over the pixel-defining layer (119),
wherein the opposite electrode (123) comprises a portion surrounding each of the first groove, H1, and the second groove, H2.

8. The display apparatus of any preceding claim, wherein an upper surface of the pixel-defining layer (119) between the second light-emitting device, OLED2, and the 1-1 light-emitting device, OLED1-1, is flat.

9. The display apparatus of any preceding claim, wherein the first emission layer (124) comprises a first sub-emission layer, EML1, and a second sub-emission layer, EML2, stacked on each other.

10. The display apparatus of claim 9, wherein the first sub-emission layer, EML1, and the second sub-emission layer, EML2, comprise materials that emit light of a same color.

11. The display apparatus of any preceding claim, further comprising an auxiliary layer (200) surrounding at least a portion of the first groove, H1, wherein at least a portion of the auxiliary layer (200) protrudes toward a center portion of the first groove, H1.

12. The display apparatus of claim 11, wherein the auxiliary layer (200) comprises at least one of silicon oxynitride, silicon oxide, or silicon nitride.

13. The display apparatus of any preceding claim, further comprising a first functional layer (126) overlapping the first charge generation layer (125) and cut off at the first groove, H1, and a second functional layer (136) overlapping the second charge generation layer (135) and spaced apart from the first functional layer (126).

## Patentansprüche

1. Anzeigevorrichtung (1), Folgendes umfassend:
ein Substrat (100);
eine 1-1 lichtemittierende Einrichtung, PX1-1, und eine 1-2 lichtemittierende Einrichtung, PX1-2, über dem Substrat (100), und die jeweils eine erste Emissionsschicht (124) und eine erste Ladungserzeugungsschicht (125) umfassen;
eine zweite lichtemittierende Einrichtung, PX2, die an die 1-1 lichtemittierende Einrichtung, PX1-1, angrenzt, und die eine zweite Emissionsschicht (134) umfassend ein Material, das Licht in einer Farbe emittiert, die sich von derjenigen der ersten Emissionsschicht (124) unterscheidet, und eine zweite Ladungserzeugungsschicht (135), die von der ersten Ladungserzeugungsschicht (125) beabstandet ist, umfasst; und
eine pixeldefinierende Schicht (119) umfassend eine Öffnung, OP, die einen mittleren Abschnitt einer Pixelelektrode (121) von jeder der 1-1 lichtemittierenden Einrichtung, PX1-1, der 1-2 lichtemittierenden Einrichtung, PX1-2, und der zweiten lichtemittierenden Einrichtung, PX2, freilegt,
wobei eine obere Oberfläche der pixeldefinierenden Schicht (119) zwischen der 1-1 lichtemittierenden Einrichtung, PX1-1, und der 1-2 lichtemittierenden Einrichtung, PX1-2, eine erste Nut, H1, umfasst, die zum Substrat (100) hin konkav ist,
wobei die erste Ladungserzeugungsschicht (125) an der ersten Nut, H1, abgeschnitten ist; und
wobei die erste Nut, H1, eine umgekehrte verjüngte Form in einer Querschnittsansicht aufweist.

2. Anzeigevorrichtung nach Anspruch 1, die ferner eine dritte lichtemittierende Einrichtung, PX3, umfasst, die an die 1-1 lichtemittierende Einrichtung und die zweite lichtemittierende Einrichtung angrenzt und so konfiguriert ist, dass sie Licht mit einer Farbe emittiert, die sich von denen der 1-1 lichtemittierenden Einrichtung und der zweiten lichtemittierenden Einrichtung unterscheidet,
wobei ein Abstand, D1, zwischen einem mittleren Abschnitt der 1-1 lichtemittierenden Einrichtung, PX1-1, und einem mittleren Abschnitt der 1-2 lichtemittierenden Einrichtung, PX1-2, größer ist als ein Abstand zwischen einem mittleren Abschnitt der zweiten lichtemittierenden Einrichtung, PX2, und einem mittleren Abschnitt der dritten lichtemittierenden Einrichtung, PX3.

3. Anzeigevorrichtung nach einem der vorhergehenden Ansprüche, wobei ein Bereich eines Emissionsbereichs von jeder der 1-1 lichtemittierenden Einrichtung, PX1-1, und der 1-2 lichtemittierenden Einrichtung, PX1-2, größer ist als ein Bereich eines Emissionsbereichs der zweiten lichtemittierenden Einrichtung, PX2.

4. Anzeigevorrichtung nach Anspruch 3, wobei die 1-1 lichtemittierende Einrichtung, OLED1-1, und die 1-2 lichtemittierende Einrichtung, OLED1-2, jeweils ein Material umfassen, das Licht mit einer Wellenlänge zwischen 450 nm und 500 nm emittiert.

5. Anzeigevorrichtung nach einem der vorhergehenden Ansprüche, die ferner eine über der pixeldefinierenden Schicht (119) angeordnete Gegenelektrode (123) umfasst,
wobei die Gegenelektrode (123) einen die erste Nut, H1, umgebenden Abschnitt umfasst.

6. Anzeigevorrichtung nach einem der vorhergehenden Ansprüche, wobei eine obere Oberfläche der pixeldefinierenden Schicht (119) zwischen der zweiten lichtemittierenden Einrichtung, PX2, und der 1-1 lichtemittierenden Einrichtung, PX1-1, eine zweite Nut, H2, umfasst, die zum Substrat (100) hin konkav ist.

7. Anzeigevorrichtung nach Anspruch 6, die ferner eine über der pixeldefinierenden Schicht (119) angeordnete Gegenelektrode (123) umfasst,
wobei die Gegenelektrode (123) einen Abschnitt umfasst, der jede von der ersten Nut, H1, und der zweiten Nut, H2, umgibt.

8. Anzeigevorrichtung nach einem der vorhergehenden Ansprüche, wobei eine obere Oberfläche der pixeldefinierenden Schicht (119) zwischen der zweiten lichtemittierenden Einrichtung, OLED2, und der 1-1 lichtemittierenden Einrichtung, OLED1-1, flach ist.

9. Anzeigevorrichtung nach einem der vorhergehenden Ansprüche, wobei die erste Emissionsschicht (124) eine erste Unter-Emissionsschicht, EML1, und eine zweite Unter-Emissionsschicht, EML2, umfasst, die übereinandergestapelt sind.

10. Anzeigevorrichtung nach Anspruch 9, wobei die erste Unter-Emissionsschicht, EML1, und die zweite Unter-Emissionsschicht, EML2, Materialien umfassen, die Licht mit derselben Farbe emittieren.

11. Anzeigevorrichtung nach einem der vorhergehenden Ansprüche, die ferner eine Hilfsschicht (200) umfasst, die mindestens einen Abschnitt der ersten Nut, H1, umgibt, wobei mindestens ein Abschnitt der Hilfsschicht (200) zu einem mittleren Abschnitt der ersten Nut, H1, hin vorsteht.

12. Anzeigevorrichtung nach Anspruch 11, wobei die Hilfsschicht (200) mindestens eines von Siliziumoxynitrid, Siliziumoxid oder Siliziumnitrid umfasst.

13. Anzeigevorrichtung nach einem der vorhergehenden Ansprüche, die ferner eine erste funktionale Schicht (126), die die erste Ladungserzeugungsschicht (125) überlappt und an der ersten Nut, H1, abgeschnitten ist, und eine zweite funktionale Schicht (136), die die zweite Ladungserzeugungsschicht (135) überlappt und von der ersten funktionalen Schicht (126) beabstandet ist, umfasst.

## Revendications

1. Appareil d'affichage (1) comprenant :
un substrat (100) ;
un dispositif électroluminescent 1-1, PX1-1, et un dispositif électroluminescent 1-2, PX1-2, par-dessus le substrat (100) et chacun comprenant une première couche d'émission (124) et une première couche de génération de charge (125) ;
un deuxième dispositif électroluminescent, PX2, adjacent au dispositif électroluminescent 1-1, PX1-1, et comprenant une deuxième couche d'émission (134) comprenant un matériau qui émet de la lumière d'une couleur différente de celle de la première couche d'émission (124) et une deuxième couche de génération de charge (135) espacée de la première couche de génération de charge (125) ; et
une couche de définition de pixels (119) comprenant une ouverture, OP, exposant une partie centrale d'une électrode de pixel (121) de chacun du dispositif électroluminescent 1-1, PX1-1, du dispositif électroluminescent 1-2, PX1-2, et du deuxième dispositif électroluminescent, PX2,
dans lequel une surface supérieure de la couche de définition de pixels (119) entre le dispositif électroluminescent 1-1, PX1-1, et le dispositif électroluminescent 1-2, PX1-2, comprend une première rainure, H1, concave en direction du substrat (100),
dans lequel la première couche de génération de charge (125) est coupée au niveau de la première rainure, H1 ; et
dans lequel la première rainure, H1, a une forme conique inversée dans une vue en coupe transversale.

2. Appareil d'affichage selon la revendication 1, comprenant en outre un troisième dispositif électroluminescent, PX3, adjacent au dispositif électroluminescent 1-1 et au deuxième dispositif électroluminescent et configuré pour émettre de la lumière d'une couleur différente de celle du dispositif électroluminescent 1-1 et du deuxième dispositif électroluminescent,
dans lequel une distance, D1, entre une partie centrale du dispositif électroluminescent 1-1, PX1-1, et une partie centrale du dispositif électroluminescent 1-2, PX1-2, est supérieure à une distance entre une partie centrale du deuxième dispositif électroluminescent, PX2, et une partie centrale du troisième dispositif électroluminescent, PX3.

3. Appareil d'affichage selon l'une quelconque des revendications précédentes, dans lequel une zone d'une zone d'émission de chacun du dispositif électroluminescent 1-1, PX1-1, et du dispositif électroluminescent 1-2, PX1-2, est supérieure à une zone d'une zone d'émission du deuxième dispositif électroluminescent, PX2.

4. Appareil d'affichage selon la revendication 3, dans lequel le dispositif électroluminescent 1-1, OLED1-1, et le dispositif électroluminescent 1-2, OLED1-2, comprennent chacun un matériau qui émet de la lumière d'une longueur d'onde comprise entre 450 nm et 500 nm.

5. Appareil d'affichage selon l'une quelconque des revendications précédentes, comprenant en outre une électrode opposée (123) disposée par-dessus la couche de définition de pixels (119),
dans lequel l'électrode opposée (123) comprend une partie entourant la première rainure, H1.

6. Appareil d'affichage selon l'une quelconque des revendications précédentes, dans lequel une surface supérieure de la couche de définition de pixels (119) entre le deuxième dispositif électroluminescent, PX2, et le dispositif électroluminescent 1-1, PX1-1, comprend une deuxième rainure, H2, concave en direction du substrat (100).

7. Appareil d'affichage selon la revendication 6, comprenant en outre une électrode opposée (123) disposée par-dessus la couche de définition de pixels (119),
dans lequel l'électrode opposée (123) comprend une partie entourant chacune de la première rainure, H1, et de la deuxième rainure, H2.

8. Appareil d'affichage selon l'une quelconque des revendications précédentes, dans lequel une surface supérieure de la couche de définition de pixels (119) entre le deuxième dispositif électroluminescent, OLED2, et le dispositif électroluminescent 1-1, OLED1-1, est plane.

9. Appareil d'affichage selon l'une quelconque des revendications précédentes, dans lequel la première couche d'émission (124) comprend une première couche de sous-émission, EML1, et une deuxième couche de sous-émission, EML2, empilées l'une sur l'autre.

10. Appareil d'affichage selon la revendication 9, dans lequel la première couche de sous-émission, EML1, et la deuxième couche de sous-émission, EML2, comprennent des matériaux qui émettent de la lumière d'une même couleur.

11. Appareil d'affichage selon l'une quelconque des revendications précédentes, comprenant en outre une couche auxiliaire (200) entourant au moins une partie de la première rainure, H1, dans lequel au moins une partie de la couche auxiliaire (200) fait saillie en direction d'une partie centrale de la première rainure, H1.

12. Appareil d'affichage selon la revendication 11, dans lequel la couche auxiliaire (200) comprend au moins l'un parmi l'oxynitrure de silicium, l'oxyde de silicium ou le nitrure de silicium.

13. Appareil d'affichage selon l'une quelconque des revendications précédentes, comprenant en outre une première couche fonctionnelle (126) chevauchant la première couche de génération de charge (125) et coupée au niveau de la première rainure, H1, et une deuxième couche fonctionnelle (136) chevauchant la deuxième couche de génération de charge (135) et espacée de la première couche fonctionnelle (126).
